Europäisches Patentamt

European Patent Office

Office européen des brevets

(11) Numéro de publication : **0 320 354 B1**

# (12) FASCICULE DE BREVET EUROPEEN

(45) Date de publication du fascicule du brevet :
**15.07.92 Bulletin 92/29**

(51) Int. Cl.⁵ : **H01J 49/40,** G01N 23/225,
H01J 37/252

(21) Numéro de dépôt : **88403067.7**

(22) Date de dépôt : **05.12.88**

(54) **Procédé d'analyse en temps de vol, à balayage continu, et dispositif d'analyse pour la mise en oeuvre de ce procédé.**

(30) Priorité : **11.12.87 FR 8717288**

(43) Date de publication de la demande :
**14.06.89 Bulletin 89/24**

(45) Mention de la délivrance du brevet :
**15.07.92 Bulletin 92/29**

(84) Etats contractants désignés :
**DE GB**

(56) Documents cités :
**DE-A- 3 144 604
US-A- 4 107 527**

(56) Documents cités :
**NUCLEAR INSTRUMENTS AND METHODS IN
PHYSICS RESEARCH, vol. B18, nos. 4-6,
février 1987, pages 446-451, Elsevier Science-
Publishers B.V., Amsterdam, NL; M.J. PELLIN
et al.: "Sensitive, low damage surface analysis using resonance ionization of sputteredatoms"
NUCLEAR INSTRUMENTS AND METHODS,
vol. 187, no. 1, août 1981, pages 143-151, Nor-
th-Holland Publising Co., Amsterdam, NL;
H.LIEBL: "Beam optics in secondary ion mass
spectrometry"**

(73) Titulaire : **CAMECA
103, Boulevard Saint-Denis
F-92400 Courbevoie (FR)**

(72) Inventeur : **Migeon, Henri
THOMSON-CSF SCPI 19, avenue de Messine
F-75008 Paris (FR)**
Inventeur : **Rasser, Bernard
THOMSON-CSF SCPI 19, avenue de Messine
F-75008 Paris (FR)**

(74) Mandataire : **Sciaux, Edmond et al
THOMSON-CSF SCPI
F-92045 PARIS LA DEFENSE CEDEX 67 (FR)**

EP 0 320 354 B1

## Description

L'invention concerne un procédé d'analyse d'échantillons solides par discrimination des temps de vol de particules arrachées à cet échantillon, et concerne un analyseur pour la mise en oeuvre de ce procédé. L'analyse en temps de vol est appliquée notamment à la spectrométrie de masse, mais elle peut être appliquée aussi à une analyse en énergie pour des particules ayant une même masse.

Un procédé d'analyse en temps de vol, de particules pulvérisées, consiste à :

- balayer la surface de l'échantillon solide par un faisceau de particules dites particules primaires, afin d'arracher à l'échantillon des particules dites secondaires ;
- ioniser les particules secondaires, au moment où elles sont arrachées ou après leur arrachement, certaines pouvant être déjà ionisées lors de la pulvérisation ;
- les accélérer par un champ électrique ;
- constituer un faisceau de particules secondaires et lui faire parcourir un chemin suffisamment long pour que des particules secondaires ayant des vitesses différentes aient des temps de vol sensiblement différents ;
- discriminer ensuite les particules secondaires à partir de leurs différences de temps de vol.

Différents points d'un échantillon étant analysés successivement, les particules secondaires les plus rapides arrachées à un point donné ont tendance à rattraper les particules secondaires les plus lentes arrachées antérieurement en un autre point de l'échantillon. Pour éviter un recouvrement, dans le temps, des particules ayant des points d'origine différents et des temps de vol différents, il est connu de réaliser une sélection temporelle en découpant par impulsions le faisceau de particules primaires ou bien le faisceau de particules secondaires. Ce procédé connu a pour inconvénient d'allonger la durée des analyses et de nécessiter un dispositif complexe pour découper l'un ou l'autre de ces faisceaux. Il est connu aussi d'utiliser un faisceau continu de particules primaires et de découper en impulsions le champ électrique utilisé pour extraire et accélérer les particules secondaires. Tous les procédés connus dans lesquels le faisceau primaire est continu mais où la mesure du courant de particules secondaires n'est pas continue, ont pour inconvénients une perte d'informations, parce que le faisceau de particules primaires érode en permanence l'échantillon alors que les mesures ne sont réalisées qu'à des instants discrets. Ces procédés ont donc une moins grande sensibilité d'analyse, que les procédés à mesure continue.

On connaît des procédés d'analyse, en masse ou en énergie, réalisant une mesure continue et ayant une très bonne résolution en utilisant une sélection géométrique au lieu d'une sélection temporelle, pour séparer des particules secondaires émises par des points distincts de l'échantillon. Ils consistent par exemple à disperser les particules secondaires de masse différente au moyen d'un champ magnétique. Cependant ils nécessitent en général un dispositif complexe et coûteux qui ne se justifie pleinement que pour obtenir une très haute résolution. Il est connu aussi des procédés d'analyse réalisant une mesure continue et une séparation géométrique en mettant en oeuvre des dispositifs beaucoup plus simples, tel qu'un quadrupôle pour réaliser une spectrométrie de masse, par exemple. Ces dispositifs sont moins coûteux et sont utilisés lorsqu'une basse résolution est suffisante. Ils ont pour inconvénient une faible sensibilité. En effet, ces dispositifs ne peuvent travailler que sur des particules secondaires de basse énergie, ce qui conduit à réduire le champ électrique de collecte et d'accélération des particules secondaires. Il en résulte une faible efficacité de la collecte et donc une faible sensibilité.

D'autre part, les appareils d'analyse modernes doivent pouvoir fournir une image de l'échantillon en cours d'analyse, par exemple pour observer des grains en minéralogie ou en métallurgie ou bien pour observer des implantations dans un dispositif de microélectronique.

Le but de la présente invention est donc de proposer un procédé d'analyse continue, en temps de vol, pouvant être mis en oeuvre au moyen d'un dispositif peu coûteux et permettant d'obtenir une image de l'échantillon analysé.

Le procédé selon l'invention combine une sélection en temps de vol et une sélection géométrique des particules secondaires. Il permet une mise en oeuvre au moyen d'un dispositif simple et procurant une résolution satisfaisante pour un grand nombre d'applications. Ce procédé fournit en outre une image de l'échantillon analysé. Des variantes de ce procédé, consistant à ajouter des dispositifs dispersifs classiques, permettent d'augmenter la résolution pour les applications où il est nécessaire d'avoir une haute résolution. Une variante de ce procédé permet de fournir simultanément plusieurs images correspondant à des particules secondaires ayant respectivement différents temps de vol, et permet de mesurer simultanément des courants de particules secondaires ayant respectivement différents temps de vol. Cette variante a notamment pour avantages de réduire la durée de l'analyse et la consommation de l'échantillon.

Selon l'invention un procédé d'analyse en temps de vol, consistant à :

- balayer périodiquement la surface d'un échantillon solide à analyser, avec un faisceau de particules dites particules primaires, pour arracher à l'échantillon des particules dites secondaires ;
- ioniser les particules secondaires, certaines étant déjà chargées ;

– les accélérer par un champ électrique ;

– constituer un faisceau de particules secondaires et lui faire parcourir un chemin suffisamment long pour que des particules secondaires ayant des énergies différentes ou des masses différentes aient des temps de vol sensiblement différents ;

– discriminer ensuite les particules secondaires à partir de leurs différences de temps de vol ;

est caractérisé en ce que, pour discriminer les particules secondaires ayant des temps de vol différents, il consiste à ramener dans une direction prédéterminée les particules secondaires ayant un temps de vol donné, quel que soit l'endroit où elles ont été arrachées sur l'échantillon, en déviant le faisceau de particules secondaires selon un angle variable en fonction du point d'émission des particules secondaires, et à des instants périodiques présentant un déphasage constant par rapport à la déviation appliquée antérieurement aux particules primaires qui les ont arrachées de l'échantillon.

Ceci permet donc d'obtenir une image de l'échantillon filtrée en temps de vol.

L'invention sera mieux comprise et d'autres détails apparaîtront à l'aide de la description ci-dessous et des figures l'accompagnant :

– La figure 1 illustre la mise en oeuvre du procédé selon l'invention ;

– La figure 2 représente schématiquement un premier exemple de réalisation d'un dispositif d'analyse pour la mise en oeuvre du procédé de l'invention ;

– Les figures 3, 4, et 5 illustrent le fonctionnement de ce premier exemple de réalisation ;

– La figure 6 représente schématiquement un second exemple de réalisation de l'analyseur pour la mise en oeuvre du procédé selon l'invention ;

– La figure 7 représente schématiquement une variante de réalisation de l'analyseur pour la mise en oeuvre du procédé selon l'invention ;

– Les figures 8 et 9 illustrent le fonctionnement de ce second exemple de réalisation.

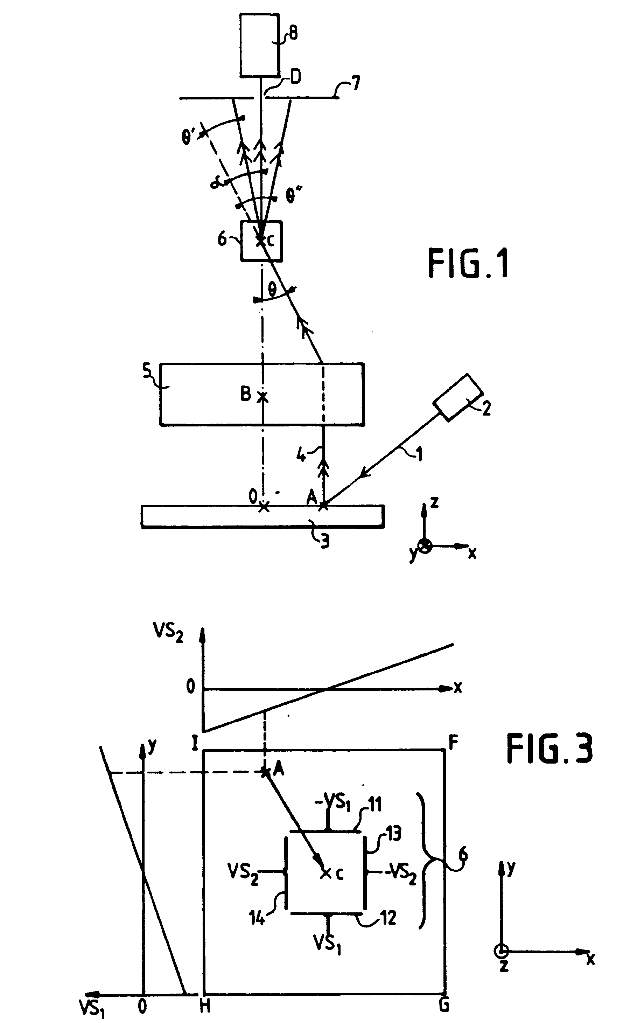

La figure 1 illustre le procédé selon l'invention, en montrant comment il permet de discriminer les particules secondaires en fonction de leur point d'origine et en fonction de leur temps de vol. Une source 2 projette un faisceau 1 de particules primaires en balayant la surface d'un échantillon 3. Considérons seulement les particules secondaires 4 arrachées à instant $t_o$ en un point A à la surface d'un échantillon solide 3. Certaines possèdent une charge électrique q due à leur ionisation. Les particules secondaires ionisées sont accélérées par un champ électrique appliqué à la surface de l'échantillon 3 et qui leur communique une énergie $E_o$. Chaque particule secondaire a une vitesse qui dépend de sa masse et de son énergie, cette dernière étant fonction de la charge q de la particule et du champ électrique accélérateur. Les particules arrachées au point A constituent alors un faisceau 4.

Les points de l'espace sont repérés dans un repère orthonormé oxyz, o étant un point au centre de la surface de l'échantillon 3, l'axe oz étant perpendiculaire à cette surface, les axes oy et ox étant parallèles à cette surface.

Un dispositif de focalisation en direction, 5, dévie le faisceau 4 pour le faire passer par un point C fixé et appartenant à l'axe oz, quelle que soit la position du point A à la surface de l'échantillon. Pour un point A donné, le faisceau 4 arrive en C en faisant un angle θ avec oz. Le temps de vol de chaque particule secondaire, pour aller de A à C, dépend de la vitesse de cette particule. Les particules ne passent donc pas toutes en C à un même instant, bien qu'elles soient toutes parties de A à l'instant $t_o$. Un dispositif de déviation 6 , ayant son centre optique situé au point C, dévie le faisceau 4 d'un angle α variable en fonction du temps. Si a un instant $t_o + t_v$, cet angle α a la valeur θ correspondant au point A, les particules passant au point C à cet instant sont ramenées sur l'axe oz. Les particules passant en C avant ou après cet instant sont déviées respectivement d'un angle θ' et θ'' différents de θ. Les valeurs respectives de θ' et θ'' dépendent du sens du balayage. Un dispositif de sélection 7 possède une entrée ponctuelle D située sur l'axe oz. Seules les particules ramenées sur l'axe oz franchissent donc l'ouverture D du dispositif de sélection 7, puis sont recueillies par un dispositif de détection 8 fournissant un courant proportionnel à la charge électrique recueillie. Les particules recueillies sont donc celles ayant un temps de vol $t_v$ tel que l'angle de déviation est égale à θ à l'instant $t_o + t_v$.

Pour que les particules secondaires émises au point A à l'instant $t_o$ et ayant un temps de vol donné $t_v$ soient recueillies par le détecteur 8, il faut et il suffit que le dispositif 6 dévie le faisceau 4, à l'instant $t_o + t_v$, d'un angle α égal à l'angle θ qui est fonction de la position (x, y) du point A à la surface de l'échantillon. Ce dispositif 6 permet donc de sélectionner le temps de vol et le point d'origine des particules secondaires recueillies par le détecteur 8. La source des particules primaires 2 balaye périodiquement la surface de l'échantillon 3 par une déviation du faisceau 1, donc la position du point A varie dans le temps et l'angle θ que fait le faisceau 4 par rapport à l'axe oz en entrant dans le dispositif de déviation 6, varie en fonction du temps.

Le procédé selon l'invention consiste essentiellement à :

– dévier le faisceau de particules secondaires 4 selon un angle variable α qui est une fonction périodique du temps, ayant la même période que celle de la déviation du faisceau de particules primaires 1 et tel que des particules secondaires ayant un temps de vol donné sont déviées à des instants périodiques ayant un déphasage constant par rapport aux instants d'application de la déviation des particules primaires qui les ont arrachées à l'échantillon 3, pour les ramener dans une direction prédéterminée, qui est oz, quel que soit le point d'origine de ces particules sur l'échantillon 3 ;

– sélectionner les particules secondaires 4 se déplaçant dans la direction prédéterminée oz ;

– mesurer le courant des particules secondaires 4 ainsi sélectionnées, ce courant traduisant la répartition à la surface de l'échantillon à analyser 3, des particules ayant le temps de vol donné.

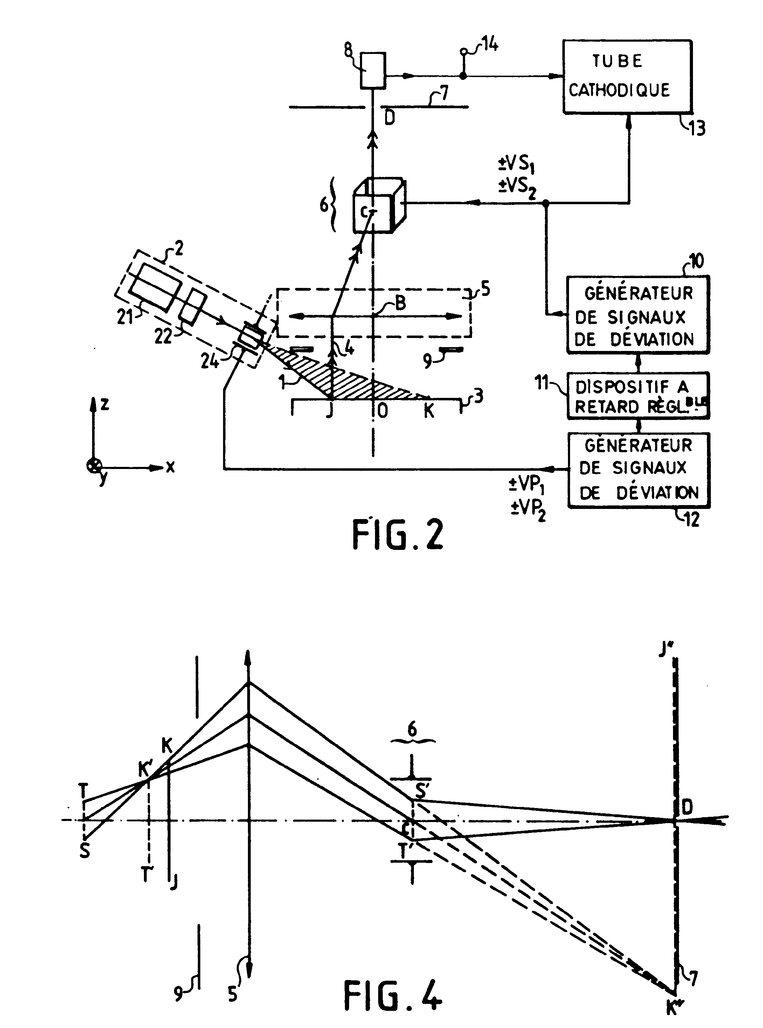

La figure 2 représente un premier exemple de réalisation d'un dispositif d'analyse pour la mise en oeuvre du procédé selon l'invention. Ce premier exemple de réalisation comporte une source 2 fournissant un faisceau 1 de particules primaires, oblique par rapport à l'axe oz. La source 2 est constituée d'une source d'ions 21, d'un dispositif optique 22 et d'un dispositif de déviation 24. Le dispositif 22 peut être constitué d'un spectromètre de masse. Le dispositif 24 comporte deux paires de plaques de déviation électrostatique raccordées à une sortie d'un générateur de signaux de déviation 12. Le dispositif 5 de focalisation en direction est constitué par une lentille électrostatique. Le dispositif de sélection 7 est un diaphragme percé d'une ouverture D, derrière laquelle est placé un détecteur 8. Une borne de sortie 14 du dispositif d'analyse est reliée à une sortie du détecteur 8 qui lui fournit un signal de mesure du courant de particules secondaires reçu par le détecteur 8 à chaque instant. Le dispositif de déviation 6 est constitué de deux paires de plaques de déviation électrostatique. Les plaques de déviation 24 sont perpendiculaires deux à deux, de même que les plaques de déviation 6 sont perpendiculaires deux à deux, afin de permettre un balayage de l'échantillon 3 selon les deux directions perpendiculaires, ox et oy.

Les plaques 6 sont reliées à une sortie d'un générateur de signaux de déviation 10. Ce dernier est synchronisé par un signal que lui fournit le générateur 12, ce signal étant transmis par un dispositif 11 à retard réglable. Un tube cathodique 13 est utilisé pour restituer une image de l'échantillon 3. La grille de commande du tube 13 est reliée à la sortie du détecteur 8 pour moduler l'intensité du faisceau électronique de ce tube, en fonction de la mesure du courant de particules secondaires ramenées dans la direction oz. Les moyens de déviation du tube 13 sont couplés à la sortie du générateur 10 pour produire un balayage de l'écran du tube 13 homologue de la déviation appliquée au faisceau de particules secondaires et en synchronisme avec le signal de mesure fourni par le détecteur 8.

Une électrode annulaire 9 permet d'appliquer un champ électrique pour extraire et accélérer les particules secondaires ionisées arrachées à la surface de l'échantillon 3. Sur cette figure, les hachures représentent le déplacement du faisceau primaire 1 pour balayer un segment JK à la surface de l'échantillon 3.

La figure 3 représente plus en détails la constitution du dispositif de déviation 6. Celui-ci comporte quatre plaques 11 à 14 portées respectivement à des potentiels $-VS_1$, $+VS_1$, $-VS_2$, $+VS_2$. Les plaques 11 et 12 permettent la déviation dans la direction oy alors que les plaques 13 et 14 permettent la déviation dans la direction ox. Elles sont placées symétriquement par rapport au centre optique C du dispositif de déviation 6. La figure 3 représente aussi deux graphes donnant la valeur du potentiel $VS_2$ et la valeur du potentiel $VS_1$ pour une déviation, du faisceau 4, correspondant à chacun des points d'une surface carrée FGHI de l'échantillon à analyser. Cette figure représente donc la relation entre les potentiels des plaques et la position (x,y) du point A d'où provient à un instant donné le faisceau 4 de particules secondaires. L'angle de déviation $\alpha$ dans le plan zox est lié au potentiel $VS_2$ par une relation de la forme :

$$tg\alpha = VS_2 \times \frac{q}{e_o} \times \frac{1}{d}$$

où d est la distance entre les plaques 13 et 14 et 1 la longueur de ces plaques suivant oz.

L'angle de déviation dans le plan yoz est lié au potentiel $VS_1$ par une formule similaire.

La figure 4 représente le trajet des particules secondaires arrachées à l'extrémité K d'un segment JK de la surface de l'échantillon, ainsi que l'effet de la déviation par le dispositif de déviation 6. L'électrode 9 donne du segment JK de l'échantillon 3 une image virtuelle J' K' éclairée par la pupille d'illumination virtuelle ST. La lentille 5 donne de l'image J'K' et de sa pupille d'illumination ST des images réelles, respectivement J" K"et S' T'. Le dispositif de déviation 6 dévie le faisceau issu du point K' vers l'ouverture D du diaphragme de sélection 7. Cette figure montre qu'il est avantageux de placer le centre optique C du dispositif de balayage 6 au niveau de l'image réelle S' T' de la pupille d'illumination car cette image reste fixe lors du balayage du faisceau 1 de particules primaires, de J à K. Il est également avantageux de placer le diaphragme de sélection 7 dans le plan de l'image réelle J" K" de la surface de l'échantillon car la dimension de l'image d'un point y est minimale, par conséquent la sélection est optimale.

Les particules primaires qui passent à un instant $t'_o$ au centre optique du dispositif de déviation 24, arrivent à la surface de l'échantillon 3 à un instant $t'_o + t_p$, avec une durée de vol $t_p$ pratiquement identique quelle que soit la position du point d'impact du faisceau 1 entre les points J et K. Les particules secondaires arrachées par ces particules primaires ont un temps de vol $t_v$ pour aller de la surface de l'échantillon 3 jusqu'au centre optique C du dispositif de déviation 6. Ces particules secondaires passent donc au point C à l'instant $t'_o + t_p + t_v$. Le temps de vol $t_v$ est pratiquement le même quelle que soit la position du point d'impact du faisceau 1 entre les points J et K. Il dépend uniquement de l'énergie et de la masse des particules secondaires arrachées à l'échantillon 3.

Pour que ces particules secondaires soient ramenées sur l'axe oz par le dispositif 6, il est nécessaire que le dispositif 6 les dévie, à l'instant $t'_o + t_p + t_v$, d'un angle correspondant à la position du point d'impact du faisceau 1 à l'instant $t'_o + t_p$. Le balayage de la surface de l'échantillon 3 par le faisceau 1 est réalisé selon un chemin prédéterminé qui est commandé par les différences de potentiel appliquées aux plaques de déviation 24. Le générateur de signaux de déviation 12 fournit respectivement aux deux paires de plaques 24 des potentiels $\pm VP_1$ et $\pm VP_2$ périodiques en fonction du temps et ayant une forme triangulaire dans cet exemple, pour réaliser un balayage de trame et un balayage de ligne. Le générateur 10 fournit des potentiels $\pm VS_1$ et $\pm VS_2$, respectivement aux deux paires de plaques du dispositif de déviation 6. Les potentiels $\pm VS_1$ et $\pm VP_1$, respectivement $\pm VS_2$ et $\pm VP_2$, ont la même fréquence mais ont un déphasage correspondant à la durée $t_p + t_v$.

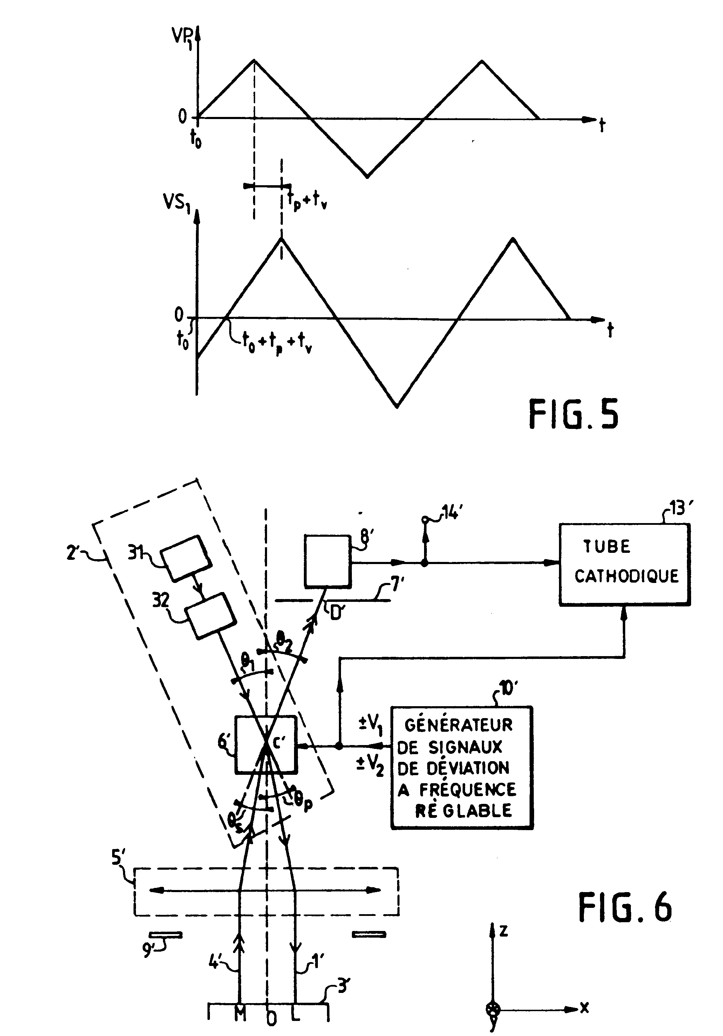

La figure 5 représente les graphes des potentiels $VP_1$ et $VS_1$ qui correspondent à la déviation selon l'axe oy. Les potentiels $VP_2$ et $VS_2$, correspondant à la déviation selon l'axe ox, ont des graphes analogues mais de fréquence différente et ne sont pas représentés. Les potentiels $VP_1$ et $VS_1$ ont des graphes ayant la même période mais déphasés, par un retard constant. En réglant le retard à la valeur $t_p + t_v$, il est possible de sélectionner des particules secondaires ayant un temps de vol donné $t_v$.

La réalisation des générateurs de signaux de déviation 10 et 12 n'est pas décrite plus en détail car elle est à la portée de l'homme de l'art.

La figure 6 représente schématiquement un second exemple de réalisation du dispositif d'analyse pour la mise en oeuvre du procédé selon l'invention, dans lequel les moyens de déviation du faisceau de particules primaires et de déviation du faisceau de particules secondaires sont confondus. Il y a pourtant un déphasage entre la déviation subie par des particules primaires et la déviation subie par des particules secondaires arrachées par ces mêmes particules primaires, car elles ne passent pas au même instant dans les moyens de déviation.

Cet exemple de réalisation est possible seulement lorsque les particules primaires et les particules secondaires ont des charges opposées. Il comporte une source 2' de faisceau primaire, constituée d'une source d'ions 31, d'un dispositif optique 32 qui peut être un spectromètre de masse, et d'un dispositif de déviation 6' qui est aussi utilisé pour dévier les particules secondaires. Cet exemple de réalisation comporte en outre un dispositif 5' de focalisation en direction, qui est constitué par exemple d'une lentille électronique ; et une électrode annulaire 9' permettant d'appliquer un champ électrique pour extraire et accélérer les particules secondaires ionisées arrachées à un échantillon 3'. Un dispositif 7' de sélection de particules est constitué par un diaphragme percé d'une ouverture ponctuelle D'. Un détecteur 8' recueille les particules ayant traversées le diaphragme 7' et fournit un signal de mesure à une borne de sortie 14' du dispositif d'analyse.

La position de ces éléments est repérée dans un repère orthonormé oxyz, le point o étant placé au centre de la surface de l'échantillon 3', l'axe oz étant normal à cette surface, et les axes ox et oy étant parallèles à cette surface. L'axe optique de la source d'ions 31 et du dispositif optique 32 sont alignés avec le centre optique C' du dispositif de déviation 6', en faisant un angle $\theta_1$ avec l'axe oz. L'axe optique de l'ouverture D' du diaphragme 7' et du détecteur 8' passe aussi par le point C' en faisant un angle $\theta_2$ avec l'axe oz. L'axe optique de la lentille 5' est confondu avec l'axe oz et passe aussi par le centre C'.

Un générateur 10' de signaux de déviation, à fréquence réglable, fournit des potentiels $\pm V_1$ et $\pm V_2$ au dispositif de déviation 6' pour réaliser un balayage de trame et un balayage de ligne respectivement. Le dispositif 6' est constitué, par exemple, de deux paires de plaques orthogonales. Les particules du faisceau primaire 1', qui arrivent au point C' à un instant donné $t_o''$, sont déviées par le dispositif 6' d'un angle $\theta_p$ par rapport à l'axe optique de la source 31 et du dispositif optique 32. Puis elles sont ramenées dans une direction proche de l'axe oz par la lentille 5'. Au même instant $t_o''$, des particules secondaires sont déviées par le dispositif 6' dans la direction C' D'. Elles vont donc traverser le diaphragme 7' et seront détectées par le détecteur 8'.

Si le dispositif est réalisé de telle manière que les angles $\theta_1$ et $\theta_2$ sont égaux, il est possible de recevoir sur le détecteur 8' des particules secondaires ayant une charge opposée à celle des particules primaires et provenant d'une direction symétrique, par rapport à l'axe oz, de la direction des particules primaires sortant du dispositif 6'.

Les particules primaires passant au centre C' à l'instant $t_o''$ frappent la surface de l'échantillon 3' en un point L à un instant ultérieur $t_o'' + t_p$ où $t_p$ est le temps de vol entre les points C' et L pour les particules primaires. Les particules secondaires arrivant au centre C' à l'instant $t_o''$ ont été arrachées précédemment en un point M de la surface de l'échantillon 3' à un instant $t_o'' - t_s$, où $t_s$ est le temps de vol entre M et C' pour les particules secondaires. Il s'écoule donc une durée $T = t_s + t_p$ entre l'instant où des particules primaires passent par le point C' et l'instant où des particules secondaires arrachées par ces particules primaires passent par ce même point C'. Par conséquent, pour détecter des particules secondaires ayant un temps de vol donné $t_v$ et qui ont été arrachées au point L par des particules primaires qui sont passées au point C' à l'instant $t_0''$, il faut et il suffit qu'à l'instant $t_0'' + T$, les potentiels $\pm V_1$ et $\pm V_2$ aient repris les mêmes valeurs qu'à l'instant $t_0''$, pour dévier les particules secondaires dans la direction de l'ouverture D', puisque, dans cet exemple, les angles $\theta_2$ et $\theta_1$ sont égaux.

Dans cet exemple, les angles $\theta_1$ et $\theta_2$ sont dans le plan xoz et le balayage de ligne est réalisé dans la direction ox. Le générateur 10' doit donc fournir un signal de déviation de ligne ayant une période T choisie en fonction du temps de vol des particules secondaires à détecter. Les particules secondaires qui n'ont pas un temps de vol correspondant à cette période ne sont pas détectées car elles arrivent en avance ou en retard au point C' et ne sont donc pas déviées d'un angle les ramenant exactement dans la direction de l'ouverture D'. Il y a donc bien sélection en temps de vol. L'amplitude des signaux de déviation de ligne $\pm V_2$ définit la largeur ML de la surface analysée sur l'échantillon 3'. La valeur moyenne de ces signaux correspond à la valeur des angles $\theta_1$ et $\theta_2$. La réalisation du générateur de signaux 10' n'est pas décrite plus en détails car elle est à la portée de l'homme de l'art.

Il est possible d'obtenir une image de la surface de l'échantillon, pour un temps de vol donné, en appliquant à la grille de commande d'un tube cathodique 13' le signal de mesure fourni par le détecteur 8'. Les moyens de déviation du tube cathodique 13' comportent des générateurs de signaux de déviation, non représentés, qui sont commandés par les potentiels $\pm V_1$ et $\pm V_2$ fournis par la sortie du générateur 10'.

Ce second exemple de réalisation est plus complexe à mettre en oeuvre que le premier car la réalisation d'une lentille 5' optimisée simultanément pour les deux faisceaux 1' et 4' est plus complexe que la réalisation de la lentille 5 optimisée seulement pour le faisceau 4.

Par contre, le second exemple de réalisation permet de rapprocher la lentille 5' de l'échantillon puisqu'il n'est pas nécessaire de laisser un passage oblique pour le faisceau de particules primaires. Ceci permet d'utiliser une lentille 5' de distance focale plus faible donc ayant moins d'aberrations et permet de réaliser une sonde plus petite.

Il a l'inconvénient de nécessiter que les particules primaires et les particules secondaires aient des charges opposées.

Les deux exemples de réalisation décrits précédemment ont une bonne résolution. La résolution peut être encore améliorée pour certaines applications en rajoutant un dispositif de filtrage ou de focalisation en énergie ou en masse. En effet, dans le cas d'une analyse de particules secondaires en masse, la distribution en énergie est un inconvénient qui affecte le pouvoir de résolution en masse du dispositif.

Deux variantes des exemples de réalisation précédents permettent de limiter cet effet. Une première variante consiste à incorporer un dispositif de filtrage en énergie, entre l'échantillon et le détecteur pour sélectionner les particules secondaires ayant une énergie comprise dans une bande dont la largeur est compatible avec la résolution en masse qui est souhaitée. Un tel dispositif de filtrage a cependant l'inconvénient d'éliminer une partie des particules secondaires et donc de diminuer la sensibilité de l'analyseur. Dans le cas du premier exemple de réalisation, le dispositif de filtrage en énergie peut être placé soit entre l'échantillon et le dispositif de déviation des particules secondaires, soit entre ce dispositif de déviation et le détecteur. Dans le cas du second exemple de réalisation, il doit être placé entre le dispositif de déviation des particules secondaires et le détecteur. La réalisation d'un tel dispositif de filtrage est classique. Il peut être constitué d'un secteur électrostatique avec une fente de sélection en énergie.

Une seconde solution consiste à intercaler un dispositif de focalisation temporelle sur le trajet des particules secondaires afin de compenser les différences de temps de vol dues aux différences d'énergie, sans compenser celles dues aux différences de masse. La résolution en masse est alors améliorée tout en conservant une large bande d'énergie donc sans perdre de la sensibilité. Ce dispositif de focalisation ne peut être utilisé que dans le premier exemple de réalisation. Il peut être intercalé entre l'échantillon et le dispositif de déviation des particules secondaires. Sa réalisation est classique. Il peut être consisté par exemple par un dispositif électrostatique dans lequel les particules d'énergies les plus élevées parcourent le plus long trajet.

Pour certaines applications nécessitant une résolution en masse encore plus élevée, les deux exemples de réalisation précédents peuvent être munis d'un spectromètre de masse d'un type classique, placé entre le diaphragme de sélection et le détecteur.

Une variante des deux exemples de réalisations décrites précédemment permet de sélectionner des particules correspondant à plusieurs temps de vols différents et provenant de différents points de la surface de l'échantillon ; et permet d'obtenir simultanément plusieurs images d'un même échantillon, correspondant à ces différents temps de vol. Cette variante de réalisation a évidemment l'avantage de réduire la durée d'une analyse et de fournir des images pour différents matériaux de l'échantillon.

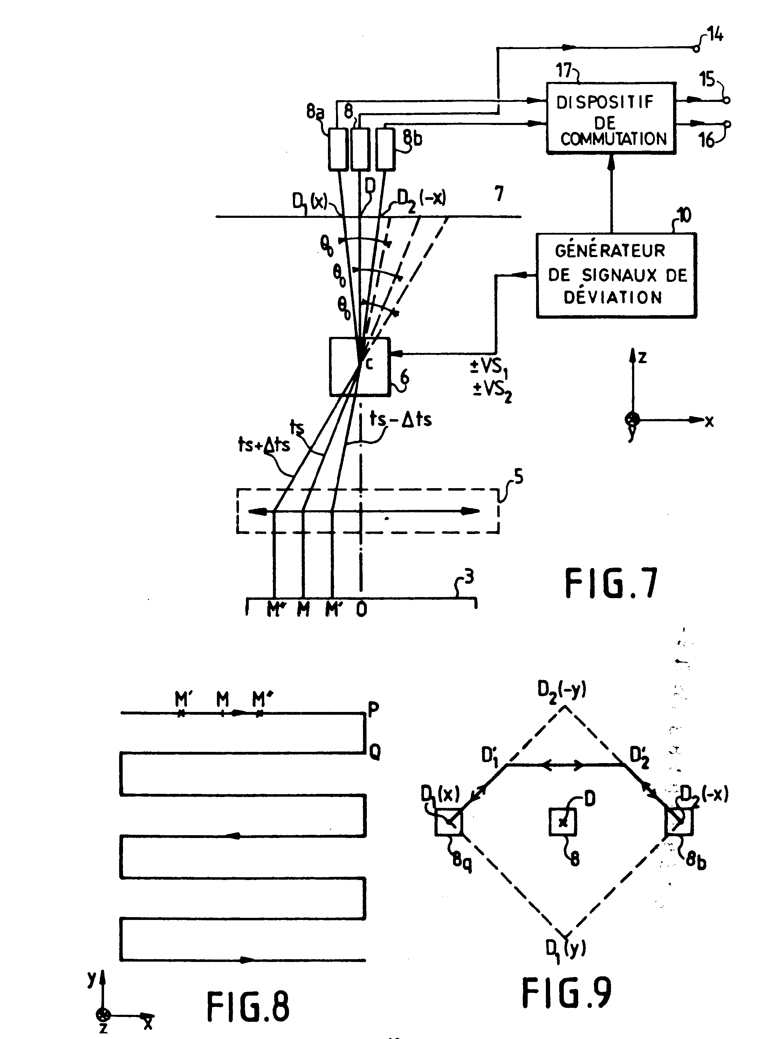

La figure 7 illustre le fonctionnement de cette variante appliquée au premier exemple de réalisation, mais sans représenter les moyens réalisant le balayage par le faisceau de particules primaires, ni l'électrode d'extraction. Cette variante peut être mise en oeuvre de manière analogue dans le second exemple de réalisation.

A un instant donné $t_o + t_s$ arrivent en C des particules secondaires émises du point M à l'instant $t_o$ et ayant un temps de vol $t_s$ de M à C. Ces particules sont déviées vers le point D où elles arrivent à l'instant $t_o + t_s + t'_s$, $t'_s$ étant le temps de vol de ces particules de C à D.

A l'instant $t_o + t_s$ arrivent également en C des particules secondaires de temps de vol différents $t_s + \Delta t_{S1}$, $t_s + \Delta t_{S2}$,... etc, provenant de points M', M'',... différents de la surface de l'échantillon. Ces particules sont déviées du même angle $\theta_o$ et arrivent donc en d'autres points $D_1$, $D_2$,... etc, aux instants $t_o + t_s + t'_{S1}$, $t_o + t_s + t'_{S2}$,...etc, où $t'_{S1}$, $t'_{S2}$,...etc, sont leurs temps de vol de C à $D_1$, $D_2$,...etc.

Dans un premier temps, pour simplifier l'explication considérons que le balayage de l'échantillon est monodimensionnel, parallèle à ox.

Les points M', M, M'' ont été balayés successivement par le faisceau de particules primaires au cours d'une même ligne de balayage, parallèle à ox. Les particules secondaires les plus lentes émises par le point M' et les particules secondaires les plus rapides émises par le point M'' arrivent au point C au même instant et subissent donc une même déviation angulaire $\theta_o$ en traversant le dispositif de déviation 6. La longueur du trajet MC étant très supérieure aux dimensions de la surface analysée sur l'échantillon 3, il est possible de montrer que la position des points $D_1$ et $D_2$ est constante pour des différences de temps de vol $\pm \Delta t_s$ fixées, quelle que soit la position des points M, M', M'' sur une même ligne de balayage. Il est à noter que les points $D_1$ et $D_2$ sont symétriques par rapport à D et sont situés sur une droite parallèle à ox, et passant par D.

D'autre part, il est à noter que les temps de vol supérieurs à $t_s$ sont sur une première demi-droite et que les temps de vol inférieurs à $t_s$ sont sur une seconde demi-droite, symétriques par rapport à D. Ces deux demi-droites permutent si le sens de balayage est inversé. Dans le cas où le balayage serait monodimensionnel, il serait donc possible de faire une détection de toutes les particules secondaires ayant des temps de vol : $t_s$, $t_s - \Delta t_s$, $t_s + \Delta t_s$, en réalisant trois ouvertures dans le diaphragme 7 aux points D, $D_1$, $D_2$, et en plaçant trois détecteurs indépendants derrière ces ouvertures.

En pratique, une analyse simultanée selon plusieurs temps de vol est compliquée par le fait que le balayage est bidimensionnel. Les temps de vol $t_s \pm \Delta t_s$ ne correspondent plus alors à deux points uniques $D_1$ et $D_2$ à la surface du diaphragme 7 car il se produit aussi un déplacement bidimensionnel du point d'impact des particules secondaires ayant des temps de vol différents de celui correspondant au point D.

La figure 8 représente le chemin parcouru par le balayage du faisceau primaire à la surface de l'échantillon 3, lorsque le signal de déviation de ligne a une forme triangulaire, avec une pente identique à la montée et à la descente, et lorsque le signal de déviation de trame a une forme en marches d'escalier correspondant à des interlignes de largeur PQ.

La figure 9 représente les points d'impact des particules secondaires ayant un temps de vol $t_s + \Delta t_s$ sur le plan du diaphragme 7. Elles arrivent au point $D_1(x)$ pendant tout le balayage d'une ligne dans le sens de l'axe ox et arrivent au point $D_2(-x)$ pendant tout le balayage d'une ligne dans le sens opposé à celui de l'axe ox, les points $D_1(x)$ et $D_2(-x)$ étant deux points symétriques de D et situés sur une droite parallèle à ox.

Inversement, les particules ayant un temps de vol $t_s - \Delta t_s$ arrivent au point $D_2(-x)$ pendant tout le balayage d'une ligne dans le sens de l'axe ox, et arrivent au point $D_1(x)$ pendant tout le balayage d'une ligne dans le sens opposé à celui de l'axe ox.

Pendant de cours intervalles de temps, situés entre le balayage de deux lignes successives et correspondant par exemple au segment PQ sur la figure 8, les particules de temps de vol $t_s \pm \Delta t_s$ n'arrivent pas en $D_1(x)$ ou $D_2(-x)$ mais arrivent sur les points de 3 segments : $D_1(x)D'_1$, $D'_1D'_2$, $D'_2D_2(-x)$, les points $D'_1$ et $D'_2$ étant inscrits sur les côtés d'un losange $D_1(x)$, $D_2(-y)$, $D_2(-x)$, $D_1(y)$ où $D_2(y)$ et $D_2(-y)$ sont les points d'impact des particules secondaires ayant des temps de vol $t_s \pm \Delta t_s$, dans le cas où le balayage serait un balayage monodimensionnel parallèle à oy.

La durée d'un changement de ligne (PQ) étant négligeable devant la durée de balayage d'une ligne, la durée pendant laquelle les particules arrivent sur les segments $D_1(x)D'_1$, $D'_1D'_2$, $D'_2D_2(-x)$ est aussi négligeable devant celle pendant laquelle elles tombent aux points $D_1(x)$ et $D_2(-x)$. Il peut donc être suffisant, dans de nombreux cas, de détecter seulement les particules aux points $D_1(x)$ et $D_2(-x)$. Il est ainsi possible, avec trois ouvertures de sélection situées en D, $D_1(x)$, $D_2(-x)$, et avec trois détecteurs, d'obtenir simultanément trois analyses et trois images de la surface de l'échantillon correspondant à des particules ayant un temps de vol ts, $t_s + \Delta t_s$ et $t_s - \Delta t_s$, en prenant soin de commuter les détecteurs au rythme du balayage pour tenir compte de la permutation du sens de balayage.

Sur la figure 7, en plus du détecteur 8 placé au point D, deux détecteurs 8a et 8b sont placés respectivement derrière des ouvertures aux points $D_1(x)$ et $D_2(-x)$, et sont reliés à deux bornes de sortie, 15 et 16, du dispositif d'analyse par un dispositif de commutation 17. Ce dernier a une entrée de commande reliée à une sortie du générateur 10 de signaux de déviation, pour recevoir un signal de commande, synchrone avec le balayage de ligne. Trois images, représentant la surface de l'échantillon 3 pour les temps de vol ts, $t_s - \Delta t_s$, et $t_s + \Delta t_s$, peuvent être restituées aux moyens de trois tubes cathodiques non représentés. Leurs grilles de commande sont reliées respectivement aux sorties des trois détecteurs 8, 8a, 8b et leurs moyens de déviation respectifs sont reliés à une sortie du générateur 10. Naturellement il est possible d'utiliser un plus grand nombre de détecteurs pour obtenir une analyse simultanée selon un plus grand nombre de temps de vol, en les alignant sur la droite $D_1(x)$ $D_2(-x)$.

L'invention est applicable à de nombreux types de dispositif d'analyse, les particules primaires pouvant être des photons (dans le cas de la seconde variante uniquement), des électrons, des ions positifs ou des ions négatifs ; les particules secondaires pouvant être des électrons, des ions positifs ou des ions négatifs.

L'invention ne se limite pas aux exemples de réalisations décrits ci-dessus, notamment les dispositifs de déviation peuvent être aussi bien de type électrostatique que de type magnétique, ou une combinaison des deux.

## Revendications

1. Procédé d'analyse en temps de vol, consistant à :
   – balayer périodiquement la surface d'un échantillon solide (3) à analyser, avec un faisceau de particules dites particules primaires (1), pour
   – arracher à l'échantillon (3) des particules dites secondaires (4) ;
   – ioniser les particules secondaires (4), certaines pouvant être déjà ionisées ;
   – les accélérer par un champ électrique ;
   – constituer un faisceau de particules secondaires (4) et lui faire parcourir un chemin suffisamment long pour que des particules secondaires ayant des énergies différentes ou des masses différentes aient des temps de vol sensiblement différents ;
   – discriminer ensuite les particules secondaires (4) à partir de leurs différences de temps de vol ; caractérisé en ce que, pour discriminer les particules secondaires ayant des temps de vol différents, il consiste à ramener dans une direction prédéterminée (oz) les particules secondaires (4) ayant un temps de vol donné, quel que soit l'endroit où elles ont été arrachées sur l'échantillon (3), en déviant le faisceau de particules secondaires (4) selon un angle variable en fonction du point d'émission des particules secondaires, et à des instants périodiques présentant un déphasage constant par rapport à la déviation appliquée antérieurement aux particules primaires (1), qui les ont arrachées de l'échantillon (3).

2. Procédé selon la revendication 1, caractérisé en ce que, pour dévier le faisceau de particules primaires (1) et pour dévier le faisceau de particules secondaires (4), il consiste à utiliser des moyens de déviation distincts (24 et 6) ayant une même période de déviation fixée ; et consiste à régler la valeur du déphasage, en fonction du temps de vol donné, en retardant les moyens de déviation du faisceau de particules secondaires (4) par rapport aux moyens de déviation du faisceau de particules primaires (1).

3. Procédé selon la revendication 1, appliqué à des particules primaires et à des particules secondaires ayant des charges opposées, caractérisé en ce que, pour dévier le faisceau de particules primaires (1) et le faisceau de particules secondaires (4), il consiste à utiliser des moyens de déviation communs (6') ; et consiste à sélectionner un temps de vol donné, en modifiant la période de déviation commune.

4. Procédé selon la revendication 1, caractérisé en ce qu'il consiste en outre à restituer une image de l'échantillon à analyser (3), en déviant le faisceau électronique d'un tube cathodique (13) selon un balayage homologue de la déviation appliquée au faisceau de particules secondaires (4) et en modulant l'intensité de ce faisceau électronique en fonction de la mesure du courant des particules secondaires (4) ramenées dans la direction prédéterminée (oz).

5. Procédé selon la revendication 1, caractérisé en ce que pour discriminer simultanément des particules secondaires ayant un temps de vol $t_s$ et des particules secondaires ayant un temps de vol $t_s + \Delta t_s$, il consiste à :
   – sélectionner les particules secondaires ramenées dans la direction prédéterminée (oz) correspondant au temps de vol donné $t_s$, et à mesurer ce courant de particules secondaires ;
   – sélectionner les particules secondaires, déviées respectivement dans deux directions ($CD_1$, $CD_2$) symétriques de la direction prédéterminée (oz), contenues dans un plan parallèle à la direction du balayage de ligne (ox), et mesurer alternativement au rythme de balayage de ligne, les 2 courants de particules secondaires ainsi sélectionnées.

6. Dispositif d'analyse pour la mise en oeuvre du procédé selon la revendication 1, comportant :
   – des moyens (2 ; 2') pour balayer périodiquement la surface d'un échantillon solide (3 ; 3') à analyser, avec un faisceau de particules dites particules primaires (1 ; 1'), pour arracher à l'échantillon (3 ; 3') des particules dites secondaires et les ioniser ;
   – des moyens (9, 5 ; 9', 5') pour accélérer les particules secondaires par un champ électrique, constituer un faisceau de particules secondaires (4 ; 4'), et lui faire parcourir un chemin suffisamment long pour que des particules secondaires ayant des énergies différentes ou des masses différentes aient des temps de vol sensiblement différents ;
   – des moyens pour discriminer les particules secondaires à partir de leurs différences de temps de vol ; caractérisé en ce que les moyens pour discriminer les particules secondaires à partir de leurs différences de temps de vol, comportent :

– des moyens (6, 10, 11 ; 10', 6') pour dévier le faisceau de particules secondaires (4, 4') selon un angle variable (α), en fonction du point d'émission du faisceau (4 ; 4') de particules secondaires et à des instants périodiques présentant un déphasage constant par rapport à la déviation que les moyens pour balayer (2 ;2') ont appliquée antérieurement au faisceau de particules primaires (1 ;1') qui a arrachées ces particules secondaires ;

– Des moyens (7, D, 8 ; 7', D', 8') pour sélectionner et mesurer le courant des particules secondaires ramenées dans la direction prédéterminée (oz).

7. Dispositif selon la revendication 6, pour la mise en oeuvre du procédé selon la revendication 2, caractérisé en ce que les moyens (6, 10, 11) pour dévier le faisceau de particules secondaires (4) sont distincts des moyens (12, 24) pour dévier le faisceau de particules primaires (1), et réalisent une déviation ayant la même période que la déviation réalisée par les moyens (6, 10) pour dévier le faisceau de particules primaires (1), mais avec un retard constant réglable ; et comportent un dispositif à retard (11) réglable en fonction du temps de vol donné.

8. Dispositif selon la revendication 6, pour la mise en oeuvre du procédé selon la revendication 3, les particules primaires et les particules secondaires ayant des charges opposées, caractérisé en ce que les moyens (6', 10') pour dévier le faisceau de particules secondaires (4') sont les mêmes que pour dévier le faisceau de particules primaires (1), et ont une période réglable en fonction du temps de vol donné.

9. Dispositif selon la revendication 6, pour la mise en oeuvre du procédé selon la revendication 4, caractérisé en ce qu'il comporte en outre un tube cathodique (13) pour fournir une image de l'échantillon (3), la grille de commande de ce tube (13) étant commandée par un signal de mesure fourni par des moyens (8) pour mesurer le courant des particules secondaires ramenées dans la direction prédéterminée (oz) ; et les moyens de déviation de ce tube (13) étant commandés par des signaux de déviation fournis par les moyens (10) pour dévier le faisceau de particules secondaires (4).

10. Dispositif selon la revendication 6, pour la mise en oeuvre du procédé selon la revendication 5, caractérisé en ce qu'il comporte en outre :

– des moyens (D₁, D₂, 8a, 8b) pour sélectionner et pour mesurer deux courants de particules secondaires (4) correspondant au temps de vol $t_s$ + $\Delta t_s$ ; ces moyens (D₁, D₂, 8a, 8b) étant disposés symétriquement par rapport aux moyens (D, 8) pour sélectionner et mesurer le courant de particules secondaires (4) correspondant au temps de vol donné $t_s$, sur une droite parallèle à la direction de balayage de ligne (ox) ;

– un dispositif de commutation (17) pour sélectionner, au rythme de balayage de ligne, l'un de ces deux courants de particules secondaires.

**Patentansprüche**

1. Verfahren für die Flugzeitanalyse, umfassend:
– periodisches Abtasten der Oberfläche einer zu analysierenden Festkörperprobe (3) mit einem Strahl von sogenannten Primärteilchen (1), um aus der Probe (3) sogenannte Sekundärteilchen (4) herauszulösen;
– Ionisieren der Sekundärteilchen (4), von denen einige bereits ionisiert worden sein können;
– Beschleunigen dieser Teilchen mittels eines elektrischen Feldes;
– Bildung eines Strahls von Sekundärteilchen (4) und Führen desselben derart, daß er einen ausreichend langen Weg durchläuft, damit Sekundärteilchen, die unterschiedliche Energien oder unterschiedliche Massen haben, im wesentlichen verschiedene Flugzeiten besitzen;
– anschließend Unterscheiden der Sekundärteilchen (4) anhand ihrer verschiedenen Flugzeiten; dadurch gekennzeichnet, daß zur Unterscheidung der Sekundärteilchen mit unterschiedlichen Flugzeiten die Sekundärteilchen (4), die unabhängig von dem Ort, an dem sie aus der Probe (3) herausgelöst worden sind, eine gegebene Flugzeit besitzen, in eine vorgegebene Richtung (oz) zurückgebracht werden durch Ablenkung des Strahls von Sekundärteilchen (4) in einem vom Emissionspunkt der Sekundärteilchen abhängigen variablen Winkel und in periodischen Zeitpunkten mit einer konstanten Phasenverschiebung in bezug auf die Ablenkung, welche vorher auf die Primärteilchen (1) ausgeübt worden ist, die die Sekundärteilchen aus der Probe (3) herausgelöst haben.

2. Verfahren gemäß Anspruch 1, dadurch gekennzeichnet, daß für die Ablenkung des Strahls von Primärteilchen (1) und für die Ablenkung des Strahls von Sekundärteilchen (4) getrennte Ablenkungsmittel (24 und 6) verwendet werden, die die gleiche feste Ablenkungsperiode haben; und daß der Phasenverschiebungswert in Abhängigkeit von der gegebenen Flugzeit durch die Verzögerung der Mittel für die Ablenkung des Strahls von Sekundärteilchen (4) in bezug auf die Mittel für die Ablenkung des Strahls von Primärteilchen (1) eingestellt ist.

3. Verfahren gemäß Anspruch 1, angewendet auf Primärteilchen und Sekundärteilchen, die entgegengesetzte Ladungen besitzen, dadurch gekennzeichnet, daß für die Ablenkung des Strahls von Primärteilchen (1) und des Strahls von Sekundärteilchen (4) gemeinsame Ablenkungsmitteln (6') verwendet werden und die Auswahl einer gegebenen Flugzeit durch die Modifikation der gemeinsamen Ablenkperiode erfolgt.

4. Verfahren gemäß Anspruch 1, dadurch gekennzeichnet, daß es außerdem die Wiederherstellung eines Bildes der zu analysierenden Probe (3) umfaßt, indem der Elektronenstrahl einer Kathodenröhre (13) gemäß einem Abtastvorgang, der zu der auf den Strahl von Sekundärteilchen (4) ausgeübten Ablenkung homolog ist, abgelenkt wird und indem die Intensität dieses Elektronenstrahls in Abhängigkeit von der Messung des Stroms der in die vorgegebene Richtung (oz) zurückgebrachten Sekundärteilchen (4) moduliert wird.

5. Verfahren gemäß Anspruch 1, dadurch gekennzeichnet, daß es für die gleichzeitige Unterscheidung von Sekundärteilchen, die eine Flugzeit ts besitzen, und von Sekundärteilchen, die eine Flugzeit $t_s + \Delta t_s$ besitzen, umfaßt:
- Auswählen der in die vorgebene Richtung (oz) zurückgebrachten Sekundärteilchen, die der gegebenen Flugzeit $t_s$ entsprechen, und Messen dieses Sekundärteilchenstroms;
- Auswählen der Sekundärteilchen, die jeweils in zwei zur vorgegebenen Richtung (oz) symmetrischen und in einer zur Zeilenabtastrichtung (ox) parallelen Ebene enthaltenen Richtungen ($CD_1$, $CD_2$) abgelenkt werden, und abwechselndes Messen im Zeilenabtast-Rhythmus der zwei auf diese Weise ausgewählten Sekundärteilchenströme.

6. Analyseeinrichtung für die Ausführung des Verfahrens gemäß Anspruch 1, mit:
- Mitteln (2; 2') zum periodischen Abtasten der Oberfläche einer zu analysierenden Festkörperprobe (3; 3') mit einem Strahl von sogenannten Primärteilchen (1; 1'), um sogenannte Sekundärteilchen aus der Probe (3; 3') herauszulösen und diese zu ionisieren;
- Mitteln (9, 5; 9', 5') zum Beschleunigen der Sekundärteilchen mittels eines elektrischen Feldes zur Bildung eines Strahls von Sekundärteilchen (4; 4') und zum Führen desselben derart, daß er einen ausreichend langen Weg durchläuft, damit Sekundärteilchen mit unterschiedlichen Energien oder unterschiedlichen Massen im wesentlichen unterschiedliche Flugzeiten aufweisen;
- Mitteln zum Unterscheiden der Sekundärteilchen anhand ihrer unterschiedlichen Flugzeiten; dadurch gekennzeichnet, daß die Mittel zum Unterscheiden der Sekundärteilchen anhand ihrer unterschiedlichen Flugzeiten umfassen:
- Mittel (6, 10, 11; 10', 6') zum Ablenken des Strahls von Sekundärteilchen (4, 4') in einem variablen Winkel ($\alpha$) in Abhängigkeit vom Emissionspunkt des Strahls (4; 4') der Sekundärteilchen und in periodischen Zeitpunkten mit einer konstanten Phasenverschiebung in bezug auf die Ablenkung, die die Mittel zum Abtasten (2; 2') vorher auf den Strahl von Primärteilchen (1; 1'), welcher diese Sekundärteilchen herausgelöst hat, ausgeübt haben;
- Mittel (7, D, 8; 7', D', 8') zum Auswählen und zum Messen des Stroms der Sekundärteilchen, die in die vorgegebene Richtung (oz) zurückgebracht worden sind.

7. Einrichtung gemäß Anspruch 6 für die Ausführung des Verfahrens gemäß Anspruch 2, dadurch gekennzeichnet, daß die Mittel (6, 10, 11) zum Ablenken des Strahls von Sekundärteilchen (4) von den Mitteln (12, 24) zum Ablenken des Strahls von Primärteilchen (1) getrennt sind und eine Ablenkung bewirken, die dieselbe Periode wie die von den Mitteln (6, 10) zum Ablenken des Strahls von Primärteilchen (1) bewirkte Ablenkung, jedoch eine einstellbare konstante Verzögerung aufweist; und eine Verzögerungseinrichtung (11) aufweisen, die in Abhängigkeit von der gegebenen Flugzeit einstellbar ist.

8. Einrichtung gemäß Anspruch 6 für die Ausführung des Verfahrens gemäß Anspruch 3, wobei die Primärteilchen und die Sekundärteilchen entgegengesetzte Ladungen besitzen, dadurch gekennzeichnet, daß die Mittel (6', 10') zum Ablenken des Strahls von Sekundärteilchen (4') dieselben wie diejenigen für die Ablenkung des Strahls von Primärteilchen (1) sind und eine in Abhängigkeit von der gegebenen Flugzeit einstellbare Periode besitzen.

9. Einrichtung gemäß Anspruch 6 für die Ausführung des Verfahrens gemäß Anspruch 4, dadurch gekennzeichnet, daß sie außerdem versehen ist mit einer Kathodenstrahlröhre (13) zum Liefern eines Bildes der probe (3), wobei das Steuergitter dieser Röhre (13) durch ein Meßsignal gesteuert wird, das von Mitteln (8) zum Messen des Stroms der in die vorgegebene Richtung (oz) zurückgebrachten Sekundärteilchen geliefert wird; und mit Ablenkmitteln für diese Röhre (13), die von Ablenksignalen gesteuert werden, die von den Mitteln (10) zum Ablenken des Strahls von Sekundärteilchen (4) geliefert werden.

10. Einrichtung gemäß Anspruch 6 für die Ausführung des Verfahrens gemäß Anspruch 5, dadurch gekennzeichnet, daß sie außerdem umfaßt:
- Mittel ($D_1$, $D_2$, 8a, 8b) zum Auswählen und zum Messen von zwei Strömen von Sekundärteilchen (4), die den Flugzeiten $t_s + \Delta t_s$ entsprechen; wobei diese Mittel ($D_1$, $D_2$, 8a, 8b) auf einer zur Zeilenabtastrichtung (ox) parallelen Geraden symmetrisch in bezug auf die Mittel (D, 8) zum Auswählen und zum Messen des Stroms der Sekundärteilchen (4), die der gegebenen Flugzeit $t_s$ entsprechen, angeordnet sind;
- eine Umschalteinrichtung (17) zum Auswählen eines dieser zwei Ströme von Sekundärteilchen im Rhythmus der Zeilenabtastung.

## Claims

1. A time of flight analysis method consisting of
– periodically sweeping the surface of a solid sample (3) to be analyzed using a beam of primary particles (1) in order to dislodge secondary particles (4) from the sample (3);
– ionizing the secondary particles (4), of which some may already be ionized;
– accelerating the same by means of an electric field;
– producing a beam of secondary particles (4) and causing it to move along a path which is sufficiently long for secondary particles having different energies or different masses to have substantially different flight times;
– then distinguishing the secondary particles (4) on the basis of their times of flight;
characterized in that in order to distinguish the secondary particles having different times of flight of it consists of returning the secondary particles (4) having a given time of flight whatever the position where they have been dislodged from the sample (3) in a predetermined direction (oz) by deflecting the beam of secondary particles (4) at a variable angle as a function of the point of emission of the secondary particles at periodic instants presenting a constant phase offset in relation to the previously caused deflection of the primary particles (1) which dislodged them from the sample (3).

2. The method as claimed in claim 1, characterized in that in order to deflect the beam of primary particles (1) and in order to deflect the beam of secondary particles (4) it consists of using separate deflection means (24 and 6) having the same set period of deflection; and it consists of regulating the degree of phase offset as a function of the given time of flight by retarding the deflection means for the beam of secondary particles (4) in relation to the deflection means for the primary particles (1).

3. The method as claimed in claim 1 as applied to primary and to secondary particles bearing opposite charges, characterized in that for deflection of the beam of primary particles (1) and the beam of secondary particles (4) it consists of using common deflection means (6'); and it consists of selecting a given flight time by modifying the common period of deflection.

4. The method as claimed in claim 1, characterized in that it furthermore consists of reconstructing an image of the sample to be analyzed (3) by deflection of the electron beam of a cathode ray tube (13) with a sweep homologous to the deflection applied to the beam of secondary particles (4) and modulating the intensity of the said electron beam as a function of the measure of the current of the secondary particles (4) returned in the predetermined direction (oz).

5. The method as claimed in claim 1, characterized in that in order to distinguish simultaneously secondary particles having a flight time $t_s$ and secondary particles having a flight time $t_s + \Delta t_s$ it consists of:
– selecting the secondary particles returned in the predetermined directions (oz) corresponding to the given flight time $t_s$ and measuring this current of secondary particles;
– selecting the secondary particles deflected respectively in two direction ($CD_1$ and $CD_2$) symmetrical with respect to the predetermined direction (oz) and contained in a plane parallel to the direction of line sweep (ox) and measuring alternatively in the line sweep rhythm the 2 secondary particle currents which have been thus selected.

6. An analysis device for performing the method as claimed in claim 1, comprising:
– means (2; 2') for periodically sweeping the surface of a solid sample (3, 3') to be analyzed with a beam of primary particles (1; 1') in order to dislodge secondary particles from the sample (3, 3') and to ionize the same;
– means (9, 5; 9', 5') in order to accelerate the secondary particles using an electric field to constitute a beam of secondary particles (4; 4') and to cause it to move along a path which is sufficiently long to cause secondary particles having different energies or different masses to have substantially different flight times;
– means for distinguishing the secondary particles on the basis of their times of flight;
characterized in that the means for distinguishing the secondary particles on the basis of their times of flight comprise:
– means (6, 10, 11; 10'; 6') for deflection of the beam of secondary particles (4, 4') through an adjustable angle ($\alpha$) as a function of the point of emission of the beam (4, 4') of the secondary particles and at periodic instants presenting a constant phase offset in relation to the deflection caused by the deflection means (2, 2') previously on the beam of primary particles (1; 1') which has dislodged these secondary particles;
– means (7, D, 8; 7', D'; 8') in order to select and to measure the current of the secondary particles returned in the predetermined direction (oz).

7. The device as claimed in claim 6 for performing the method as claimed in claim 2, characterized in that the means (6, 10; 11 ) for the deflection of the beam of secondary particles (4) are separate from the means (12; 24) for the deflection of the beam of primary particles (1 ) and cause a deflection having the same period as the deflection caused by the means (6; 10) for the deflection of the beam of primary particles (1) but with an adjustable constant delay; and comprise a delay means (11) able to be adjusted as a function of a given flight time.

8. The device as claimed in claim 6 for performing the method as claimed in claim 3, the primary particles and the secondary particles having opposite charges, characterized in that the means (6'; 10') for the deflection of the secondary particles (4') are the same as those for the deflection of the beam of primary particles (1) and have a period which is adjustable as a function of the given flight time.

9. The device as claimed in claim 6 for performing the method as claimed in claim 4, characterized in that it furthermore comprises a cathode ray tube ( 13) in order to provide an image of the sample (3), the control grid of the tube (13) being controlled by a measure signal provided by means (8) for the measuring the current of the secondary particles returned in the predetermined direction (oz); and the deflection means of the said tube (13) being controlled by deflection signals provided by the means (10) for the deflection of the beam of secondary particles (4).

10. The device as claimed in claim 6 for performing the method as claimed in claim 5, characterized in that it furthermore comprises:

– means ($D_1$, $D_2$, 8a, 8b) for the selection and measurement of two currents of the secondary particles (4) corresponding to a flight time $t_s$ + $\Delta t_s$ ; said means ($D_1$, $D_2$, 8a, 8b) being arranged symmetrically with respect to the means (D, 8) for the selection and the measurement of the current of the secondary particles (4) corresponding to the given flight time $t_s$ on a straight line parallel to the direction of the line sweep (ox); and

– a switching device (17) for the selection, in step with the line sweep, of one of the two currents of the secondary particles.

FIG.1

FIG.3

13

FIG.2

FIG.4

FIG.5

FIG.6

FIG.7

FIG.8

FIG.9